# EUROPEAN PATENT SPECIFICATION

(11) **EP 4 410 066 B1**
(45) Date of publication and mention of the grant of the patent: **04.11.2026**
(21) Application number: 22877293.5
(22) Date of filing: 29.09.2022
(51) Int. Cl.: H05K 7/20, B64C 1/38, B64D 47/00, B64D 13/00

(54) **SYSTEMS AND METHODS FOR THERMAL MANAGEMENT OF EXTERNALLY MOUNTED ELECTRONIC EQUIPMENT FOR AN AIRCRAFT**
SYSTEME UND VERFAHREN ZUR WÄRMEVERWALTUNG EINER EXTERN MONTIERTEN ELEKTRONISCHEN AUSRÜSTUNG FÜR EIN FLUGZEUG
SYSTÈMES ET PROCÉDÉS DE GESTION THERMIQUE D'ÉQUIPEMENT ÉLECTRONIQUE MONTÉ À L'EXTÉRIEUR POUR UN AÉRONEF

(30) Priority: 30.09.2021 US 202163250642 P
(43) Date of publication of application: 07.08.2024
(73) Proprietor: TRAK TECOM Corporation, Tampa, FL 33634 (US)
(72) Inventor: O BRIEN, Shawn Kalen, St. Petersburg, Florida (US); WILKERSON, James Allan, Melbourne, Florida 32940 (US); JANURA, Ardian Dudi, Moorpark, California 93021 (US)
(74) Representative: Vienne, Aymeric Charles Emile
(86) International application number: PCT/US2022/045134
(87) International publication number: WO 2023/055868

(56) References cited:
- WO-A1-2021/062305
- DE-A1- 102009 023 175
- DE-A1- 102009 023 175
- US-A- 4 504 030
- US-A- 4 504 030
- US-A- 4 674 704
- US-A- 5 481 433
- US-A- 5 894 987
- US-A1- 2002 024 221
- US-A1- 2002 024 221
- US-A1- 2002 101 715
- US-A1- 2002 101 715
- US-A1- 2008 099 630
- US-A1- 2009 277 993
- US-A1- 2015 232 191
- US-A1- 2015 232 191
- US-A1- 2017 027 088
- US-A1- 2017 027 088
- US-B1- 6 330 153
- US-B1- 6 330 153

## Description

### BACKGROUND

The embodiments described herein relate generally to thermal management systems and, more particularly, to a thermal management system for cooling of externally mounted electronic equipment on an aircraft.

Electronics assemblies, such transmitters and receivers for electronic communication, may be mounted to the exterior of aircraft. These electronics assemblies must provide adequate cooling for internal circuits to prevent damage caused by overheating. Because there is generally no cooling fluid flow or ability to transfer heat into the aircraft structure, systems located within the aircraft cannot be used to perform this cooling, and airflow around the aircraft must be used. For higher power assemblies, the available outside surface area of the assembly may not be sufficient to transfer enough heat into the airflow to meet the cooling needs of these assemblies. Further, these assemblies must be capable of surviving the airborne environment, meeting structural requirements, and meeting maintenance and safety requirements. In addition, these systems must also perform at low aircraft speed or while the aircraft is stopped at a gate, when limited or no airflow is available. Accordingly, a thermal management system capable of effectively cooling an electronics assemblies mounted on the exterior of an aircraft while maintaining structural integrity is desirable.
US 2015/232191 discloses a cooling system for components in airborne vehicle structures. The device cools a component by means of a cooling air flow, wherein the device has at least one air inlet and at least one air outlet, which are arranged such that the cooling air flow is adjusted from the air inlet to the air outlet as a result of a difference in pressure produced during movement of the vehicle as a result of varying high flow velocities of the ambient air.
US 2017/027088 discloses a cooling apparatus for cooling electronic device in an aircraft.
US 4 674 704 discloses a direct air cooling system for airborne electronics. WO 2021/062305 discloses a vehicle cabin thermal management technology.

### BRIEF SUMMARY

Aspects of the invention are recited in the independent claims and preferred features are recited in the dependent claims.

In one aspect, a thermal management system for an aircraft is provided. The thermal management system includes a housing extending between a leading end and a trailing end. The housing includes a cooling structure defining at least one inlet, at least one outlet, and a duct coupled in flow communication between the at least one inlet and the at least one outlet. The cooling structure is configured to generate a fluid flow from the at least one inlet to the at least one outlet through the duct in response to the housing moving through a fluid. The at least one inlet is located closer to the trailing end of said housing than the at least one outlet, the duct being configured to guide the fluid to flow through the housing from the trailing end towards the leading end so that air generally moves through the duct in a direction that is the same as the direction of movement of the aircraft.

The thermal management system further includes an upper housing. The upper housing and the cooling structure define an electronics enclosure. The thermal management system further includes an electronics assembly disposed in the electronics enclosure of the housing in contact with the cooling structure. The cooling structure is configured to transfer heat generated by the electronics assembly to the fluid moving through the duct to cool the electronics assembly.

In another aspect, a method for manufacturing a thermal management system is provided. The method includes forming a cooling structure that defines at least one inlet, at least one outlet, and a duct coupled in flow communication between the at least one inlet and the at least one outlet. The cooling structure is configured to generate a fluid flow from the at least one inlet to the at least one outlet through the duct towards in response to moving through a fluid, wherein the at least one inlet is located closer to the trailing end of said housing than the at least one outlet, the duct being configured to guide the fluid to flow through the housing from the trailing end towards the leading end. The method further includes positioning an electronics assembly in contact with the cooling structure. The cooling structure is configured to transfer heat generated by the electronics assembly to the fluid moving through the duct to cool the electronics assembly. The method further includes coupling an upper housing to the cooling structure to define an electronics enclosure. The electronics assembly is disposed in the electronics enclosure, the upper housing and cooling structure form a housing extending between a leading end and a trailing end, and wherein the cooling structure is configured to cause the fluid to move through the duct.

In another aspect, a housing for a thermal management system is provided. The housing extends between a leading end an a trailing end and includes a cooling structure defining at least one inlet, at least one outlet, and a duct coupled in flow communication between the at least one inlet and the at least one outlet. The cooling structure is configured to generate a fluid flow from the at least one inlet to the at least one outlet through the duct in response to the housing moving through a fluid. The at least one inlet is located closer to the trailing end of said housing than the at least one outlet, the duct being configured to guide the fluid to flow through the housing from the trailing end towards the leading end so that air generally moves through the duct in a direction that is the same as the direction of movement of the aircraft. The housing further includes an upper housing. The housing and the cooling structure define an electronics enclosure. An electronics assembly is disposed in the electronics enclosure of the housing in contact with the cooling structure, and the cooling structure is configured to transfer heat generated by the electronics assembly to the fluid moving through the duct to cool the electronics assembly.

### BRIEF DESCRIPTION OF THE DRAWINGS

FIGS. 1-7 show example embodiments of the systems and methods described herein.
FIG. 1 is a perspective view of an example thermal management system;
FIG. 2 is a side elevation view of the thermal management system shown in FIG. 1;
FIG. 3 is a plan view of the thermal management system shown in FIGS. 1 and 2;
FIG. 4 is an exploded view of the thermal management system shown in FIGS. 1-3;
FIG. 5 is a cross-sectional view of the thermal management system shown in FIGS. 1-4;
FIG. 6 is a vector diagram illustrating a fluid flow with respect to a vertical cross-section of the thermal management system shown in FIGS. 1-5;
FIG. 7 is a vector diagram illustrating a fluid flow with respect to a horizontal cross-section of the thermal management system shown in FIGS. 1-6;
FIG. 8 is a perspective view of an example transmitter array for use in the thermal management system shown in FIGS. 1-7; and
FIG. 9 is a flowchart of an example method of manufacturing the thermal management system shown in FIGS 1-7.

### DETAILED DESCRIPTION

In the following specification and the claims, reference will be made to a number of terms, which shall be defined to have the following meanings.

The singular forms "a", "an", and "the" include plural references unless the context clearly dictates otherwise.

Approximating language, as used herein throughout the specification and claims, is applied to modify any quantitative representation that could permissibly vary without resulting in a change in the basic function to which it is related. Accordingly, a value modified by a term or terms, such as "about", "approximately", and "substantially", is not to be limited to the precise value specified. In at least some instances, the approximating language may correspond to the precision of an instrument for measuring the value. Here and throughout the specification and claims, range limitations are combined and interchanged, such ranges are identified and include all the sub-ranges contained therein unless context or language indicates otherwise.

The disclosed systems and methods include a thermal management system including a housing having a leading end and a trailing end. The housing may be mounted on an exterior surface of an aircraft, with the leading end oriented towards a front of the aircraft, and the trailing end oriented towards a rear of the aircraft. The housing includes a cooling structure defining at least one inlet, at least one outlet, and a duct coupled in flow communication between the at least one inlet and the at least one outlet. The cooling structure is configured to generate a fluid flow from the at least one inlet to the at least one outlet through the duct in response to the housing moving through a fluid such as air. In some embodiments, the at least one inlet is located closer to the trailing end than the outlet, so that air generally moves through the duct in a direction that is the same as the direction of movement of the aircraft.

The housing also includes an upper housing (sometimes referred to herein as a "radome") that defines an electronics enclosure with the cooling structure. The thermal management system further includes an electronics assembly disposed in the electronics enclosure of the housing. The electronics assembly includes electronic components that generate heat, such as steered antenna arrays and associated transmitter and receiver circuitry. The electronics assembly is in contact with the cooling structure, so that the cooling structure transfers heat generated by the electronics assembly to the fluid moving through the duct to cool the electronics assembly. In certain embodiments, the cooling structure also includes a phase change thermal storage material, such as paraffin wax, that stores heat generated by the electronics assembly at a constant temperature by changing from a solid phase to a liquid phase.

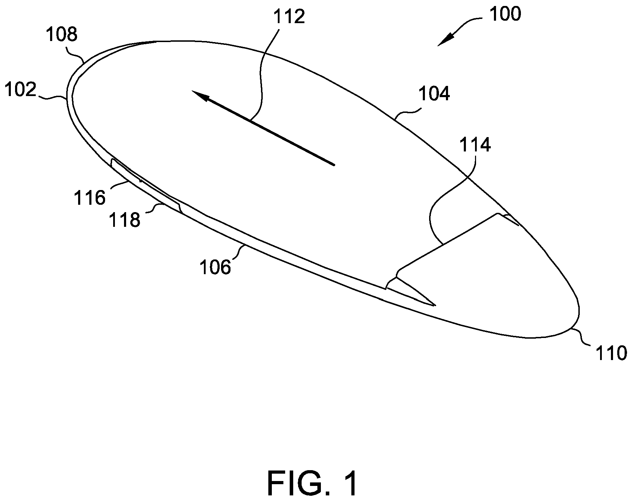

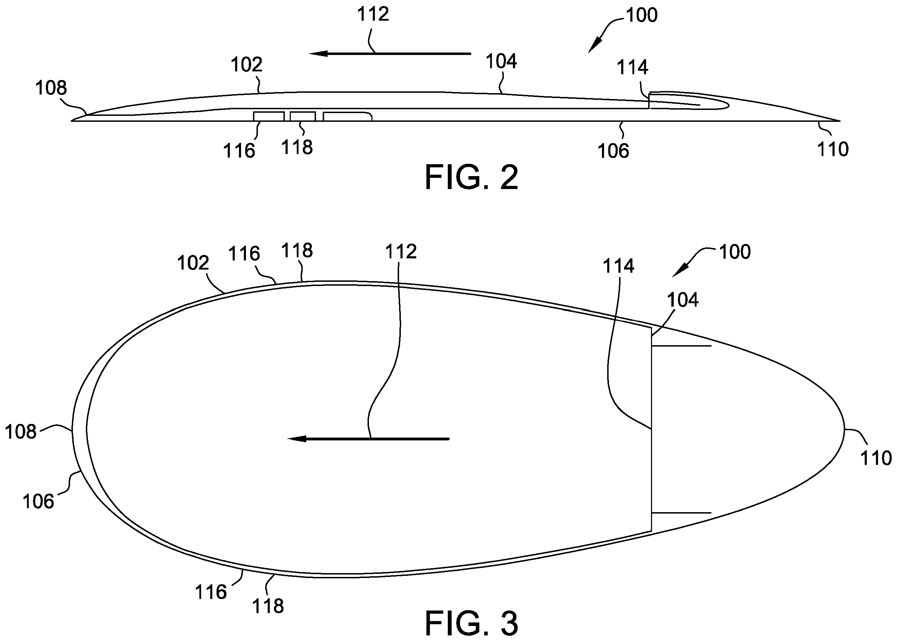

FIGS. 1-3 illustrate an example thermal management system 100. Thermal management system 100 includes a housing 102, which, in some embodiments, includes a radome 104 and a lower housing 106. Lower housing 106 is configured to be attached to an external surface of a moving vehicle or machine such as an aircraft. Housing 102 has a leading end 108 and a trailing end 110 with respect to a forward direction 112 of movement of the aircraft or other vehicle on which housing 102 is mounted.

Radome 104 is shaped to reduce drag and turbulence in order to reduce heating resulting from friction and to reduce effects on aircraft flight characteristics. In certain embodiments, such as those in which thermal management system 100 includes RF transmitting and receiving elements, radome 104 is constructed of composite materials that achieve a defined and desired RF performance. Thermal and aerodynamic performance of thermal management system 100 depend on a geometric shape of the radome 104 and housing 102 and surface characteristics of radome 104. For example, an absorption coefficient of radome 104 may vary from 0.15 for white painted surface to 0.45 dark gray painted surface. In some embodiments, radome 104 includes thermal insulation or is otherwise configured to reduce heat from solar radiation reaching components located within housing 102, enabling thermal management system 100 to maintain cooling efficiency under high solar thermal loads.

Housing 102 defines an inlet 114 and at least one outlet 116, which are coupled in flow communication via a duct 118. Accordingly, as housing 102 moves through a fluid such as air in forward direction 112, the fluid flows into housing 102 via inlet 114, through duct 118, and out of housing 102 via outlet 116. In some embodiments, as shown in FIG. 1, inlet 114 is located proximate to trailing end 110 of housing 102, and outlet 116 is located forward of inlet 114, nearer to leading end 108. Alternatively, inlet 114 and outlet 116 may each either be located near leading end 108 or trailing end 110, and either inlet 114 or outlet 116 may be located nearer to leading end 108. Inlet 114 and outlet 116 are shaped and positioned to maintain structural integrity in the event of impact events, such as bird strikes. For example, inlet 114 and/or outlet 116 may be positioned such that 114 and/or outlet 116 are within a boundary layer of the aircraft and are shielded from direct impact, such as by being positioned on a side-facing portion of housing 102 near an outer surface of the aircraft. In certain embodiments, inlet 114 is located on an upper surface of housing 102, adjacent to radome 104, and outlet 116 is located on a side-facing surface of housing 102.

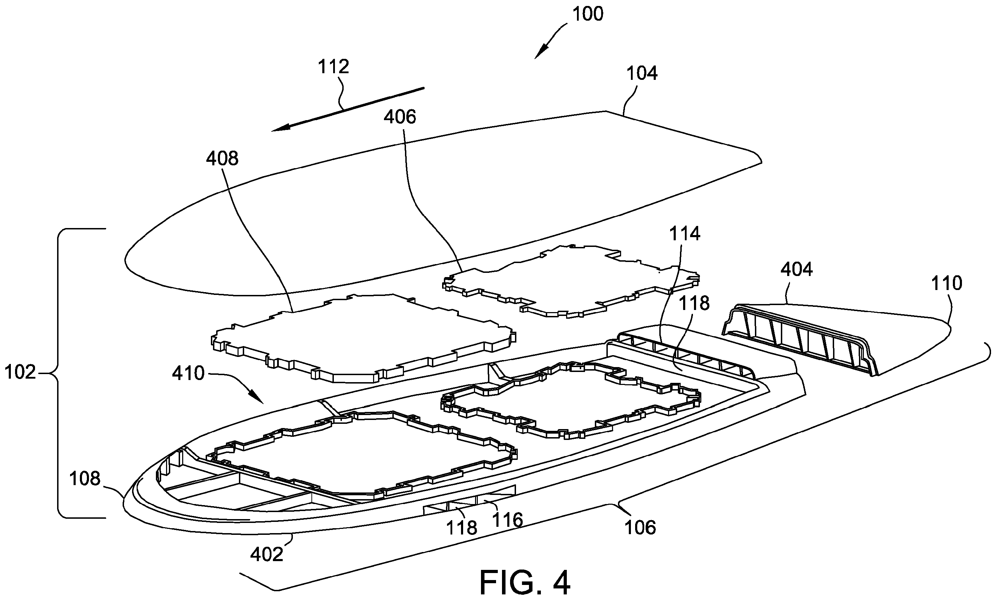

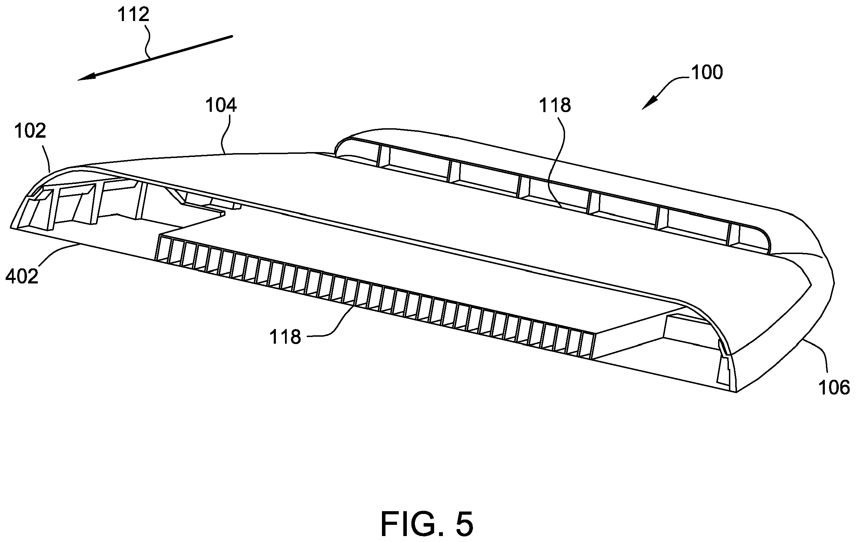

FIG. 4 is an exploded view of thermal management system 100, and FIG. 5 is a cross-sectional view of thermal management system 100. As shown in FIG. 4, lower housing 106 includes a cooling structure 402 and an aft fairing 404. Inlet 114, outlet 116, and duct 118 are defined in cooling structure 402. Thermal management system 100 further includes a transmitter array 406 and a receiver array 408, which are disposed within an environmentally sealed electronics enclosure 410 formed by radome 104 and lower housing 106. Transmitter array 406 and receiver array 408 each include respective arrays of antennas and other active and passive components for transmitting and receiving electronic communications signals such as pulse-code modulation (PCM) signals. These components generate heat, which may be dissipated into air moving through duct 118 to cool transmitter array 406 and receiver array 408. Transmitter array 406 and receiver array 408 are positioned in contact with cooling structure 402, such that heat may passively transfer from transmitter array 406 and receiver array 408, through cooling structure 402, and into air moving through duct 118.

As shown in FIG. 5, in some embodiments, cooling structure 402 includes cooling fins 502 that increase a surface area of duct 118 to facilitate a greater transfer of heat. Because cooling structure 402 is directly coupled to the heat sources of transmitter array 406 and receiver array 408, thermal management system may not include additional passive heat transfer components. Further, no active cooling components are present within housing 102, and no heat load is transferred to the aircraft fuselage.

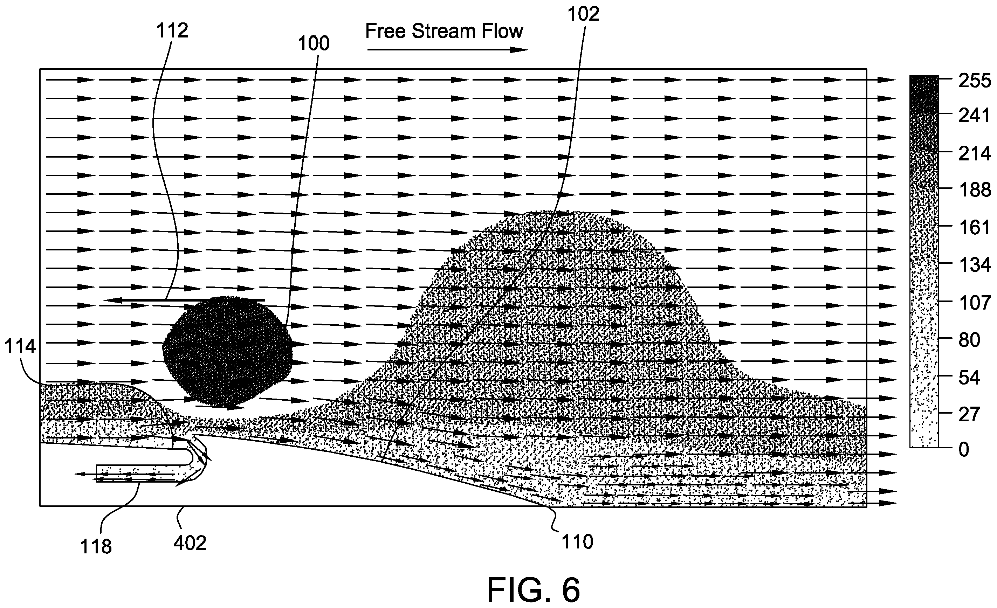

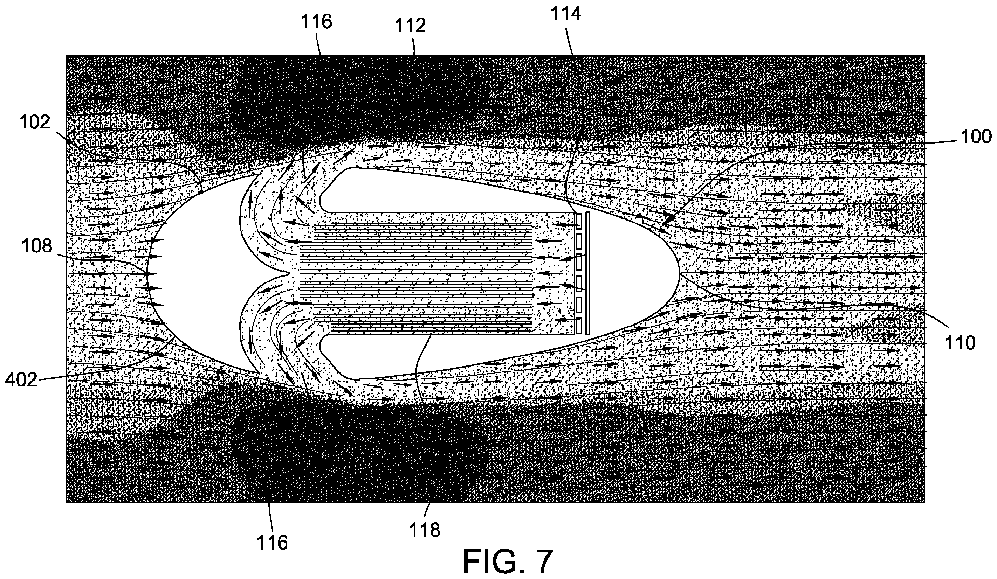

FIGS. 6 and 7 are vector diagrams illustrating a fluid flow through housing 102. As shown in FIG. 6, fluid, such as air, moves into duct 118 at inlet 114. Duct 118 guides the fluid to flow through housing 102 from trailing end 110 towards leading end 108. In other words, air moves through duct 118 in the same forward direction 112 of movement as housing 102. In some embodiments, air slightly accelerates as it moves through duct 118. In certain embodiments, an airflow velocity within duct 118 is well below freestream velocity, which reduces levels of induced acoustic pressure that is generated due to air passage through narrow channels.

Further, as shown in FIG. 7, the fluid moves between cooling fins 502 to cool transmitter array 406 and receiver array 408 through cooling structure 402 before laterally exiting housing 102 at outlet 116. In some embodiments, duct 118 has a high aspect ratio, in that a width of duct 118 is greater than a height of duct 118, which enables housing 102 to have a low profile and overall height for reduced aerodynamic effects. After exiting outlet 116, air moves into an external low-pressure region, which reduces flow shearing effects and turbulence.

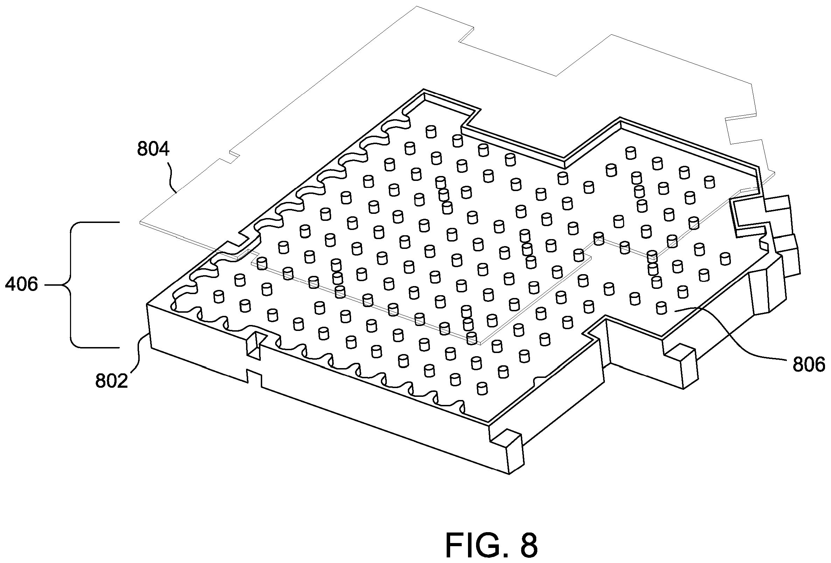

FIG. 8 is a perspective view of an example transmitter array 406. In certain embodiments, receiver array 408 has a similar structure to transmitter array 406 as shown in FIG. 8. Transmitter array 406 includes a lid 802 and a mounting base 804.

In some embodiments, transmitter array 406 further includes a phase-change thermal storage material 806 disposed in contact with mounting base 804. Additionally or alternatively, thermal storage material such as phase-change thermal storage material 806 may be disposed at different locations within thermal management system 100, which enables thermal management system 100 to cool electronic components such as transmitter array 406 and receiver array 408 under low airflow conditions, such as when the aircraft on which thermal management system 100 is mounted is taxiing or at a gate. Phase-change thermal storage material 806 may be, for example, a paraffin wax material that melts to store heat during low airflow conditions, and becomes solid during high airflow conditions to dissipate the heat to the air through cooling structure 402. The phase-change characteristic of phase-change thermal storage material 806 enables heat to be stored at a constant temperature (i.e., the melting temperature of the phase-change thermal storage material). The critical temperature of phase-change thermal storage material 806 may be tailored to meet the requirements of a specific operating environment and temperature limits of the electronic equipment. For example, a melting point of paraffin wax varies with molecular weight, so wax compositions with melting points between 50 degrees Celsius and 75 degrees Celsius may be readily obtained. A mass of phase-change thermal storage material 806 may be selected to allow sufficient time for the equipment to operate when the aircraft is at the gate or during taxi operations without exceeding a maximum operating temperature. In other words, phase-change thermal storage material 806 should be sufficiently massive such that it continues to store heat for the duration of the low airflow conditions without increasing in temperature by becoming melted entirely.

In addition, in certain embodiments, thermal management system 100 is configured to use phased power reduction strategies to extend time in which temperature may be controlled in low airflow conditions. For example, transmitter array 406 and/or receiver array 408 may be operated in a low power mode, in which non-essential functions of transmitter array 406 and receiver array 408 are switched off and remaining critical functions operated in lower power modes. This can include, for example, operation at lower transmit duty cycle, shutdown of antenna elements in transmitter array 406 and/or receiver array 408 (e.g., using a sparsely-populated array concept), reduction of peak transmit power, and/or shutdown of non-essential functions.

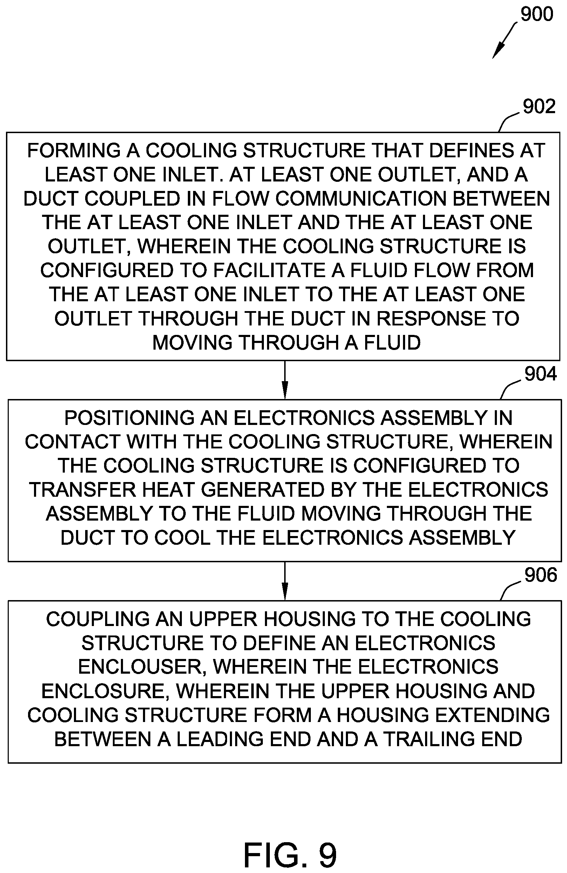

FIG. 9 is a flowchart of an example method 900 for manufacturing a thermal management system such as thermal management system 100. Method 900 includes forming 902 a cooling structure (such as cooling structure 402) that defines at least one inlet (such as inlet 114), at least one outlet (such as outlet 116), and a duct (such as duct 118) coupled in flow communication between the at least one inlet and the at least one outlet. The cooling structure is configured to generate a fluid flow from the at least one inlet to the at least one outlet through the duct in response to moving through a fluid, for example, by moving through air by being mounted on an exterior surface of an aircraft.

Method 900 further includes positioning 904 an electronics assembly (such as transmitter array 406 and/or receiver array 408) in contact with the cooling structure. The cooling structure is configured to transfer heat generated by the electronics assembly to the fluid moving through the duct to cool the electronics assembly.

Method 900 further includes coupling 906 an upper housing (such as radome 104) to the cooling structure to define an electronics enclosure (such as electronics enclosure 410). The electronics assembly is disposed in the electronics enclosure, and the upper housing and cooling structure form a housing (such as housing 102) extending between a leading end (such as leading end 108) and a trailing end (such as trailing end 110).

The at least one inlet is located closer to the trailing end of the housing that the at least one outlet, and the cooling structure is configured to cause the fluid to move through the duct towards the leading end.

In certain embodiments, the cooling structure includes a phase change thermal storage material configured to store heat generated by the electronics assembly at a constant temperature by changing from a solid phase to a liquid phase.

Example embodiments of methods and systems for thermal management of electronic components are described above in detail. The methods and systems are not limited to the specific embodiments described herein, but rather, components of systems and/or steps of the methods may be used independently and separately from other components and/or steps described herein. Accordingly, the example embodiments can be implemented and used in connection with many other applications not specifically described herein. herein, insofar as they fall within the scope of the appended claims.

Technical effects of the systems and methods described herein include: (a) improved cooling of electronic components mounted on an aircraft by utilizing a housing defining a duct configured to generate an airflow in the same direction as the direction of motion of the aircraft to transfer heat from the electronic components; and (b) improved cooling of electronic components mounted on an aircraft in low airflow conditions by utilizing a phase change thermal storage material configured to store heat at a constant temperature by changing from a solid phase to a liquid phase.

## Claims

1. A thermal management system (100) for an aircraft, comprising:
a housing (102) extending between a leading end (108) and a trailing end (110), said housing comprising:
a cooling structure (402) defining at least one inlet (114), at least one outlet (116), and a duct (118) coupled in flow communication between the at least one inlet and the at least one outlet, wherein said cooling structure is configured to generate a fluid flow from the at least one inlet to the at least one outlet through the duct in response to said housing moving through a fluid, and
an upper housing (104), said upper housing and said cooling structure defining an electronics enclosure (410), and
an electronics assembly (406, 408) disposed in the electronics enclosure of said housing in contact with said cooling structure, wherein said cooling structure is configured to transfer heat generated by said electronics assembly to the fluid moving through the duct to cool said electronics assembly,
**characterised in that** the at least one inlet (114) is located closer to the trailing end of said housing than the at least one outlet (116), the duct (118) being configured to guide the fluid to flow through the housing (102) from the trailing end (110) towards the leading end (108) so that air generally moves through the duct in a direction that is the same as the direction of movement of the aircraft.

2. The thermal management system (100) of Claim 1, wherein said cooling structure further comprises a phase change thermal storage material configured to store heat generated by said electronics assembly by changing from a solid phase to a liquid phase.

3. The thermal management system (100) of Claim 2, wherein said phase change thermal storage material comprises a paraffin wax material, or
wherein said phase change thermal storage material has a melting point in a range from 50 degrees Celsius to 75 degrees Celsius.

4. The thermal management system (100) of Claim 1, wherein said cooling structure comprises a plurality of cooling fins extending into the duct.

5. The thermal management system (100) of Claim 1, wherein the electronics enclosure is disposed between said upper housing and the duct defined by said cooling structure.

6. The thermal management system (100) of Claim 1, wherein said upper housing comprises thermal insulation.

7. The thermal management system (100) of Claim 1, wherein the at least one inlet is disposed on an upper surface of said cooling structure.

8. The thermal management system (100) of Claim 1, wherein the at least one outlet is disposed on a side-facing surface of said cooling structure.

9. The thermal management system (100) of Claim 1, wherein the fluid is air.

10. The thermal management system (100) of Claim 1, wherein said housing is attached to an exterior surface of an aircraft.

11. The thermal management system (100) of Claim 1, wherein said electronics assembly comprises at least one of a transmitter array and/or a receiver array, or
wherein said electronics assembly is configured to operate in a low power mode when said housing is not moving through the fluid.

12. A method (900) for manufacturing a thermal management system, said method comprising:
forming (902) a cooling structure that defines at least one inlet, at least one outlet, and a duct coupled in flow communication between the at least one inlet and the at least one outlet, wherein the cooling structure is configured to generate a fluid flow from the at least one inlet to the at least one outlet through the duct in response to moving through a fluid, wherein the at least one inlet (114) is located closer to the trailing end of said housing than the at least one outlet (116), the duct (118) being configured to guide the fluid to flow through the housing (102) from the trailing end (110) towards the leading end (108);
positioning (904) an electronics assembly in contact with the cooling structure, wherein the cooling structure is configured to transfer heat generated by the electronics assembly to the fluid moving through the duct to cool the electronics assembly; and
coupling (906) an upper housing to the cooling structure to define an electronics enclosure, wherein the electronics assembly is disposed in the electronics enclosure, wherein the upper housing and cooling structure form a housing extending between a leading end and a trailing end, and wherein the cooling structure is configured to cause the fluid to move through the duct.

13. The method (900) of Claim 12, wherein the cooling structure includes a phase change thermal storage material configured to store heat generated by the electronics assembly by changing from a solid phase to a liquid phase.

14. A housing (102) for the thermal management system (100) of Claim 1, said housing extending between a leading end (108) and a trailing end (110), and comprising:
a cooling structure (402) defining at least one inlet (114), at least one outlet (116), and a duct (118) coupled in flow communication between the at least one inlet and the at least one outlet, wherein said cooling structure is configured to generate a fluid flow from the at least one inlet to the at least one outlet through the duct in response to said housing moving through a fluid; and
an upper housing (104), said upper housing and said cooling structure defining an electronics enclosure (410), wherein the electronics enclosure of the housing is configured to receive an electronics assembly (406, 408) in contact with said cooling structure, and wherein said cooling structure is configured to transfer heat generated by the electronics assembly to the fluid moving through the duct to cool the electronics assembly,
**characterised in that** the at least one inlet (114) is located closer to the trailing end of said housing than the at least one outlet (116), the duct (118) being configured to guide the fluid to flow through the housing (102) from the trailing end (110) towards the leading end (108) so that air generally moves through the duct in a direction that is the same as the direction of movement of the aircraft.

15. The housing (102) of Claim 14, wherein said cooling structure further comprises a phase change thermal storage material configured to store heat generated by the electronics assembly by changing from a solid phase to a liquid phase.

## Patentansprüche

1. Wärmemanagementsystem (100) für ein Luftfahrzeug, das Folgendes umfasst:
ein Gehäuse (102), das sich zwischen einem vorderen Ende (108) und einem hinteren Ende (110) erstreckt, wobei das Gehäuse Folgendes umfasst:
eine Kühlstruktur (402), die wenigstens einen Einlass (114), wenigstens einen Auslass (116) und einen Kanal (118) definiert, der zwischen dem wenigstens einen Einlass und dem wenigstens einen Auslass in Fluidverbindung gekoppelt ist, wobei die Kühlstruktur dazu konfiguriert ist, als Reaktion darauf, dass sich das Gehäuse durch ein Fluid bewegt, eine Fluidströmung von dem wenigstens einen Einlass zu dem wenigstens einen Auslass durch den Kanal zu erzeugen,
ein oberes Gehäuse (104), wobei das obere Gehäuse und die Kühlstruktur eine Elektronikumhüllung (410) definieren; und
eine Elektronikbaugruppe (406, 408), die in der Elektronikumhüllung des Gehäuses in Kontakt mit der Kühlstruktur angeordnet ist, wobei die Kühlstruktur dazu konfiguriert ist, die von der Elektronikbaugruppe erzeugte Wärme an das durch den Kanal strömende Fluid zu übertragen, um die Elektronikbaugruppe zu kühlen,
**dadurch gekennzeichnet, dass** sich der wenigstens eine Einlass (114) näher an dem hinteren Ende des Gehäuses befindet als der wenigstens eine Auslass (116), wobei der Kanal (118) dazu konfiguriert ist, das Fluid zu führen, um durch das Gehäuse (102) von dem hinteren Ende (110) zu dem vorderen Ende (108) zu strömen, sodass sich die Luft im Allgemeinen durch den Kanal in einer Richtung bewegt, die dieselbe ist wie die Bewegungsrichtung des Luftfahrzeugs.

2. Wärmemanagementsystem (100) nach Anspruch 1, wobei die Kühlstruktur ferner ein Phasenwechselwärmespeichermaterial umfasst, das dazu konfiguriert ist, die von der Elektronikbaugruppe erzeugte Wärme durch das Ändern von einer festen Phase in eine flüssige Phase zu speichern.

3. Wärmemanagementsystem (100) nach Anspruch 2, wobei das Phasenwechselwärmespeichermaterial ein Paraffinwachsmaterial umfasst, oder
wobei das Phasenwechselwärmespeichermaterial einen Schmelzpunkt in einem Bereich von 50 Grad Celsius bis 75 Grad Celsius aufweist.

4. Wärmemanagementsystem (100) nach Anspruch 1, wobei die Kühlstruktur eine Mehrzahl von Kühlrippen umfasst, die sich in den Kanal hinein erstrecken.

5. Wärmemanagementsystem (100) nach Anspruch 1, wobei die Elektronikumhüllung zwischen dem oberen Gehäuse und dem durch die Kühlstruktur definierten Kanal angeordnet ist.

6. Wärmemanagementsystem (100) nach Anspruch 1, wobei das obere Gehäuse eine Wärmeisolierung umfasst.

7. Wärmemanagementsystem (100) nach Anspruch 1, wobei der wenigstens eine Einlass an einer oberen Oberfläche der Kühlstruktur angeordnet ist.

8. Wärmemanagementsystem (100) nach Anspruch 1, wobei der wenigstens eine Auslass an einer seitengewandten Oberfläche der Kühlstruktur angeordnet ist.

9. Wärmemanagementsystem (100) nach Anspruch 1, wobei das Fluid Luft ist.

10. Wärmemanagementsystem (100) nach Anspruch 1, wobei das Gehäuse an einer Außenoberfläche eines Luftfahrzeugs befestigt ist.

11. Wärmemanagementsystem (100) nach Anspruch 1, wobei die Elektronikbaugruppe wenigstens entweder einen eines Senderarrays und/oder eines Empfängerarrays umfasst, oder
wobei die Elektronikbaugruppe dazu konfiguriert ist, in einem Energiesparmodus betrieben zu werden, wenn sich das Gehäuse nicht durch das Fluid bewegt.

12. Verfahren (900) zum Herstellen eines Wärmemanagementsystems, wobei das Verfahren Folgendes umfasst:
Ausbilden (902) einer Kühlstruktur, die wenigstens einen Einlass, wenigstens einen Auslass und einen Kanal definiert, der zwischen dem wenigstens einen Einlass und dem wenigstens einen Auslass in Fluidverbindung gekoppelt ist, wobei die Kühlstruktur als Reaktion auf das Bewegen durch ein Fluid dazu konfiguriert ist, eine Fluidströmung von dem wenigstens einen Einlass zu dem wenigstens einen Auslass durch den Kanal auszubilden, wobei sich der wenigstens eine Einlass (114) näher an dem hinteren Ende des Gehäuses befindet als der wenigstens eine Auslass (116), wobei der Kanal (118) dazu konfiguriert ist, das Fluid zu führen, um durch das Gehäuse (102) von dem hinteren Ende (110) zu dem vorderen Ende (108) zu strömen;
Positionieren (904) einer Elektronikbaugruppe in Kontakt mit der Kühlstruktur, wobei die Kühlstruktur dazu konfiguriert ist, die von der Elektronikbaugruppe erzeugte Wärme an das sich durch den Kanal bewegende Fluid zu überzutragen, um die Elektronikbaugruppe zu kühlen; und
Koppeln (906) eines oberen Gehäuses mit der Kühlstruktur, um eine Elektronikumhüllung zu definieren, wobei die Elektronikbaugruppe in der Elektronikumhüllung angeordnet ist, wobei das obere Gehäuse und die Kühlstruktur ein Gehäuse ausbilden, das sich zwischen einem vorderen Ende und einem hinteren Ende erstreckt, und wobei die Kühlstruktur dazu konfiguriert ist, zu bewirken, dass sich das Fluid durch den Kanal bewegt.

13. Verfahren (900) nach Anspruch 12, wobei die Kühlstruktur ein Phasenwechselwärmespeichermaterial enthält, das dazu konfiguriert ist, die von der Elektronikbaugruppe erzeugte Wärme durch das Ändern von einer festen Phase in eine flüssige Phase zu speichern.

14. Gehäuse (102) für das Wärmemanagementsystem (100) nach Anspruch 1, wobei sich das Gehäuse zwischen einem vorderen Ende (108) und einem hinteren Ende (110) erstreckt und Folgendes umfasst:
eine Kühlstruktur (402), die wenigstens einen Einlass (114), wenigstens einen Auslass (116) und einen Kanal (118) definiert, der zwischen dem wenigstens einen Einlass und dem wenigstens einen Auslass in Fluidverbindung gekoppelt ist, wobei die Kühlstruktur dazu konfiguriert ist, als Reaktion darauf, dass sich das Gehäuse durch ein Fluid bewegt, eine Fluidströmung von dem wenigstens einen Einlass zu dem wenigstens einen Auslass durch den Kanal zu erzeugen; und
ein oberes Gehäuse (104), wobei das obere Gehäuse und die Kühlstruktur eine Elektronikumhüllung (410) definieren, wobei die Elektronikumhüllung des Gehäuses dazu konfiguriert ist, eine Elektronikbaugruppe (406, 408) aufzunehmen, die mit der Kühlstruktur in Kontakt steht, und wobei die Kühlstruktur dazu konfiguriert ist, die von der Elektronikbaugruppe erzeugte Wärme an das sich durch den Kanal bewegende Fluid abzugeben, um die Elektronikbaugruppe zu kühlen,
**dadurch gekennzeichnet, dass** sich der wenigstens eine Einlass (114) näher an dem hinteren Ende des Gehäuses befindet als der wenigstens eine Auslass (116), wobei der Kanal (118) dazu konfiguriert ist, das Fluid zu führen, um durch das Gehäuse (102) von dem hinteren Ende (110) zu dem vorderen Ende (108) zu strömen, sodass sich die Luft im Allgemeinen durch den Kanal in einer Richtung bewegt, die dieselbe ist wie die Bewegungsrichtung des Luftfahrzeugs.

15. Gehäuse (102) nach Anspruch 14, wobei die Kühlstruktur ferner ein Phasenwechselwärmespeichermaterial umfasst, das dazu konfiguriert ist, die von der Elektronikbaugruppe erzeugte Wärme durch das Ändern von einer festen Phase in eine flüssige Phase zu speichern.

## Revendications

1. Système de gestion thermique (100) pour un aéronef, comprenant :
un boîtier (102) s'étendant entre une extrémité avant (108) et une extrémité arrière (110), ledit boîtier comprenant :
une structure de refroidissement (402) définissant au moins une entrée (114), au moins une sortie (116) et un conduit (118) accouplé en communication fluidique entre l'au moins une entrée et l'au moins une sortie, dans lequel ladite structure de refroidissement est conçue pour générer un écoulement de fluide de l'au moins une entrée à l'au moins une sortie à travers le conduit en réponse au déplacement dudit boîtier à travers un fluide,
un boîtier supérieur (104), ledit boîtier supérieur et ladite structure de refroidissement définissant un coffret électronique (410) ; et
un ensemble électronique (406, 408) disposé dans le coffret électronique dudit boîtier en contact avec ladite structure de refroidissement, dans lequel ladite structure de refroidissement est conçue pour transférer de la chaleur générée par ledit ensemble électronique au fluide se déplaçant à travers le conduit pour refroidir ledit ensemble électronique,
**caractérisé en ce que** l'au moins une entrée (114) est située plus près de l'extrémité arrière dudit boîtier que l'au moins une sortie (116), le conduit (118) étant conçu pour guider le fluide de manière qu'il s'écoule à travers le boîtier (102) à partir de l'extrémité arrière (110) vers l'extrémité avant (108) de sorte que de l'air se déplace généralement à travers le conduit dans une direction qui est la même que la direction de déplacement de l'aéronef.

2. Système de gestion thermique (100) selon la revendication 1, dans lequel ladite structure de refroidissement comprend en outre un matériau de stockage thermique à changement de phase conçu pour stocker de la chaleur générée par ledit ensemble électronique par changement d'une phase solide à une phase liquide.

3. Système de gestion thermique (100) selon la revendication 2, dans lequel ledit matériau de stockage thermique à changement de phase comprend un matériau en cire de paraffine, ou
dans lequel ledit matériau de stockage thermique à changement de phase présente un point de fusion dans une plage de 50 degrés Celsius à 75 degrés Celsius.

4. Système de gestion thermique (100) selon la revendication 1, dans lequel ladite structure de refroidissement comprend une pluralité d'ailettes de refroidissement s'étendant dans le conduit.

5. Système de gestion thermique (100) selon la revendication 1, dans lequel le coffret électronique est disposé entre ledit boîtier supérieur et le conduit défini par ladite structure de refroidissement.

6. Système de gestion thermique (100) selon la revendication 1, dans lequel ledit boîtier supérieur comprend une isolation thermique.

7. Système de gestion thermique (100) selon la revendication 1, dans lequel l'au moins une entrée est disposée sur une surface supérieure de ladite structure de refroidissement.

8. Système de gestion thermique (100) selon la revendication 1, dans lequel l'au moins une sortie est disposée sur une surface orientée latéralement de ladite structure de refroidissement.

9. Système de gestion thermique (100) selon la revendication 1, dans lequel le fluide est de l'air.

10. Système de gestion thermique (100) selon la revendication 1, dans lequel ledit boîtier est fixé à une surface extérieure d'un aéronef.

11. Système de gestion thermique (100) selon la revendication 1, dans lequel ledit ensemble électronique comprend au moins un réseau parmi un réseau d'émetteurs et/ou un réseau de récepteurs, ou
dans lequel ledit ensemble électronique est conçu pour fonctionner dans un mode basse puissance lorsque ledit boîtier ne se déplace pas à travers le fluide.

12. Procédé (900) de fabrication d'un système de gestion thermique, ledit procédé comprenant :
la formation (902) d'une structure de refroidissement qui définit au moins une entrée, au moins une sortie et un conduit accouplé en communication fluidique entre l'au moins une entrée et l'au moins une sortie, dans lequel la structure de refroidissement est conçue pour générer un écoulement de fluide de l'au moins une entrée à l'au moins une sortie à travers le conduit en réponse au déplacement à travers un fluide, dans lequel l'au moins une entrée (114) est située plus près de l'extrémité arrière dudit boîtier que l'au moins une sortie (116), le conduit (118) étant conçu pour guider le fluide de manière qu'il s'écoule à travers le boîtier (102) à partir de l'extrémité arrière (110) vers l'extrémité avant (108) ;
le positionnement (904) d'un ensemble électronique en contact avec la structure de refroidissement, dans lequel la structure de refroidissement est conçue pour transférer de la chaleur générée par l'ensemble électronique au fluide se déplaçant à travers le conduit pour refroidir l'ensemble électronique ; et
l'accouplement (906) d'un boîtier supérieur à la structure de refroidissement pour définir un coffret électronique, dans lequel l'ensemble électronique est disposé dans le coffret électronique, dans lequel le boîtier supérieur et la structure de refroidissement forment un boîtier s'étendant entre une extrémité avant et une extrémité arrière, et dans lequel la structure de refroidissement est conçue pour amener le fluide à se déplacer à travers le conduit.

13. Procédé (900) selon la revendication 12, dans lequel la structure de refroidissement comporte un matériau de stockage thermique à changement de phase conçu pour stocker de la chaleur générée par l'ensemble électronique par changement d'une phase solide à une phase liquide.

14. Boîtier (102) pour le système de gestion thermique (100) selon la revendication 1, ledit boîtier s'étendant entre une extrémité avant (108) et une extrémité arrière (110), et comprenant :
une structure de refroidissement (402) définissant au moins une entrée (114), au moins une sortie (116) et un conduit (118) accouplé en communication fluidique entre l'au moins une entrée et l'au moins une sortie, dans lequel ladite structure de refroidissement est conçue pour générer un écoulement de fluide de l'au moins une entrée à l'au moins une sortie à travers le conduit en réponse au déplacement dudit boîtier à travers un fluide ; et
un boîtier supérieur (104), ledit boîtier supérieur et ladite structure de refroidissement définissant un coffret électronique (410), dans lequel le coffret électronique du boîtier est conçu pour recevoir un ensemble électronique (406, 408) en contact avec ladite structure de refroidissement, et dans lequel ladite structure de refroidissement est conçue pour transférer de la chaleur générée par l'ensemble électronique au fluide se déplaçant à travers le conduit pour refroidir l'ensemble électronique,
**caractérisé en ce que** l'au moins une entrée (114) est située plus près de l'extrémité arrière dudit boîtier que l'au moins une sortie (116), le conduit (118) étant conçu pour guider le fluide de manière qu'il s'écoule à travers le boîtier (102) à partir de l'extrémité arrière (110) vers l'extrémité avant (108) de sorte que de l'air se déplace généralement à travers le conduit dans une direction qui est la même que la direction de déplacement de l'aéronef.

15. Boîtier (102) selon la revendication 14, dans lequel ladite structure de refroidissement comprend en outre un matériau de stockage thermique à changement de phase conçu pour stocker de la chaleur générée par l'ensemble électronique par changement d'une phase solide à une phase liquide.
